# EUROPEAN PATENT SPECIFICATION

(11) **EP 3 890 095 B1**
(45) Date of publication and mention of the grant of the patent: **18.11.2026**
(21) Application number: 20167241.7
(22) Date of filing: 31.03.2020
(51) Int. Cl.: H01M 10/42, G08C 23/04, H04B 10/11, H01M 50/20, H01M 50/572, H04B 10/114

(54) **BATTERY SYSTEM WITH LIGHT-BASED COMMUNICATION**
BATTERIESYSTEM MIT LICHTBASIERTER KOMMUNIKATION
SYSTÈME DE BATTERIE AYANT UNE COMMUNICATION BASÉE SUR LA LUMIÈRE

(43) Date of publication of application: 06.10.2021
(73) Proprietor: Samsung SDI Co., Ltd., Gyeonggi-do 17084 (KR)
(72) Inventor: Hofer, Maximilian, 8230 Hartberg (AT); Klobasa, Roland, 8051 Graz (AT); Kraberger, Gernot, 8010 Graz (AT)
(74) Representative: Gulde & Partner

(56) References cited:
- DE-A1- 102017 204 138
- US-A- 6 094 031
- US-A1- 2018 109 328
- US-A1- 2019 229 376

## Description

### Field of the Invention

The present invention relates to a battery system with light-based communication, particularly to light-based communication between control units within the battery system as well as to a specific layout of a battery system for increasing efficiency of light-based communication.

### Technological Background

A rechargeable or secondary battery differs from a primary battery in that it can be repeatedly charged and discharged, while the latter provides only an irreversible conversion of chemical to electrical energy. Low-capacity rechargeable batteries are used as power supply for small electronic devices, such as cellular phones, notebook computers and camcorders, while high-capacity rechargeable batteries are used as the power supply for hybrid and electric vehicles and the like.

In general, rechargeable batteries include an electrode assembly including a positive electrode, a negative electrode, and a separator interposed between the positive and negative electrodes, a case receiving the electrode assembly, and electrode terminals electrically connected to the positive and negative electrodes of the electrode assembly, respectively. An electrolyte solution is injected into the case in order to enable charging and discharging of the battery via an electrochemical reaction of the positive electrode, the negative electrode, and the electrolyte solution. The shape of the case, e.g. cylindrical or prismatic, depends on the battery's intended purpose.

Rechargeable batteries may be used as a battery module formed of a plurality of unit battery cells coupled in series and/or in parallel so as to provide a high energy density, particularly high voltage and capacity, e.g. for an electric vehicle. That is, the battery module is formed by interconnecting the electrode terminals of the plurality of unit battery cells depending on a required amount of power and in order to realize a high-power rechargeable battery, e.g. for an electric vehicle. Battery modules are mechanically and electrically integrated, equipped with a passive or active thermal management system and set up for communication with electrical loads in order to form a battery system. Aspects of mechanical and electric integration and thermal management are not essential for the present disclosure.

Battery modules can be constructed either in block design or in modular design. In block designs, each battery cell is coupled to a common current collector structure and a common battery system manager. In modular designs, pluralities of battery cells are connected to form submodules and several submodules are connected to form the battery module. Battery management functions may be realized either on module or submodule level and thus interchangeability of the components is improved. One or more battery modules are mechanically and electrically integrated, equipped with a thermal management system and set up for communication with one or more electrical consumers to form a battery system.

For meeting the dynamic power demands of the various electrical loads connected to the battery system a static control of battery power output and charging is not sufficient. Thus, steady or intermittent exchange of information between the battery system and the controllers of the electrical consumers is required. This information includes the battery system's actual state of charge (SoC), potential electrical performance, charging ability and internal resistance as well as actual or predicted power demands or surpluses of the consumers.

For monitoring, controlling and/or setting of the aforementioned parameters a battery system usually comprises one or more of a battery system monitor (BSM), a battery disconnect unit (BDU), and a battery module monitor (BMM). Such control units may be an integral part of the battery system and disposed within a common housing or may be part of a remote control unit communicating with the battery system via a suitable communication bus.

These control units may perform various functions in the battery system. A BMM is equipped on battery module or submodule level and is configured for measuring cell voltages and possibly also temperatures and to provide cell balancing within the modules. A plurality of BMMs is usually connected for data transmission among each other and with a BSM, wherein the BSM receives the measured data, particularly voltage (and possibly temperature) data, from all battery modules, controls the battery system as a whole, and provides a communication interface to an exterior of the battery system for communicating with the electrical consumers, e.g. via a suitable communication bus such as a CAN or SPI interface.

The BSM is usually coupled to the controller of one or more electrical consumers as well as to each of the BMMs of the battery modules of the battery system. For controlling a plurality of battery modules by a single BSM a daisy chain setup may be used. In such setup, the BSM, as master, is connected for communication in series to a plurality of battery modules, particularly to the plurality of battery module monitors, BMM, of the respective battery modules.

Daisy chain setups and corresponding protocols are commonly used in the art.

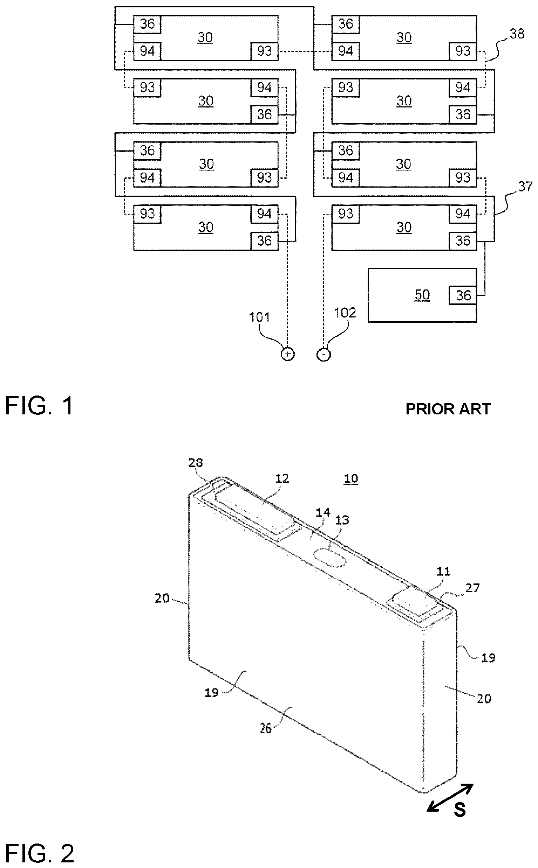

An exemplary battery system with a daisy chain setup according to the prior art is illustrated in Figure 1. Therein, a BSM 50 is setup for communication with a plurality of BMMs 30 of battery modules, each BMM 30 comprising a negative module terminal 93 and a positive module terminal 94. The module terminals 93, 94 of BMMs 30 are power connected to each other via busbars 38 and peripheral module terminals 93, 94 are power connected to system terminals 101, 102, respectively. Each BMM 30 further comprises a connector 36 for setting up a daisy chain with the BSM 50 which also comprises such connector 36 using a wiring harness 37 connecting the all of the connectors 36 with each other in a serial configuration.

Using the wiring harness 37 principally provides a great flexibility for positioning the connectors 36 due to the mechanical flexibility of the wiring harness 37 itself. However, the wire-based connections of the wiring harness 37 are disadvantageously subject to failure by electromagnetic disturbances and further are sources for EM disturbances themselves. Hence, screening or EMI shielding of the wiring harness 37 is required further limiting the already restricted available construction space for the wiring harness 37. Also, the material and assembly costs of the wire harness increase the battery system's overall costs.

For the above reasons, light-based communication can be principally used in a battery system in an advantageous manner. However, in light-based communication any obstruction in a line of sight between a light transmitter and receiver could deteriorate the communication. Also reflection and/or absorption properties of the battery system's components might interfere with the light medium used for communication and have thus to be considered.

Thus, the use of light-based communication in battery systems usually requires mirrors and/or housing components in setting up an obstruction free light communication path, which disadvantageously increases the complexity and the costs of the battery system as whole.

It is thus an object of the present invention to overcome or reduce at least some of the drawbacks of the prior art and to provide a battery system with a light-based communication between BSM and battery modules that is of low complexity and manufacturing costs.

Conventional devices are known from DE 10 2017 204 138 A1 and US 6 094 031 A.

### Description of the Invention

One or more of the drawbacks of the prior art could be avoided or at least reduced by means of the present disclosure. In particular, a battery system is provided that comprises a plurality of battery modules, wherein each of the plurality of battery modules comprises a plurality of stacked battery cells that might be interconnected between module terminals. Further, each of the battery modules comprises a battery module monitor, BMM, that is configured for monitoring the cells, wherein each BMM is disposed on top of each battery module. Particularly, each of the BMMs is configured for measuring e.g. voltages, currents and/or temperatures of the cells of the respective battery module and may further be configured to perform cell balancing between the battery cells of the battery modules. In the context of the present disclosure, this definition of a battery module may be complete, i.e., a battery module described here may be a battery submodule as described in the introduction. However, the battery module described here may also comprise further components.

The battery system further comprises a battery system monitor, BSM, that is configured for communicating with and controlling the BMM of each battery module. The BMS is preferably configured to receive voltage data from the BMMs of all battery modules and further to control the battery system as a whole- The BSM is preferably further configured to provide a communication interface to an exterior of the battery system for communicating with electrical loads connected thereto.

The battery system of the present disclosure further comprises a housing that is enclosing the plurality of battery modules and the BSM. The housing comprises preferably a ground plate, a plurality of side walls and a cover, the combination of which encloses the battery modules and the BSM from all sides. At least one of the aforementioned components may be removable, e.g., to allow service access to the battery system. The battery system is preferably made of a metal, such as e.g., aluminum or steel or is made of a plastic material.

In the battery system of the present disclosure, the battery modules are arranged in the housing such that at least one swelling compensation channel is formed between the battery modules and/or between the battery modules and the housing. In other words, the battery modules are arranged such that sufficient space is provided between the modules and/or the housing for accounting for swelling of the battery modules, particularly sufficient space for compensating cell swelling during operation of the battery modules. Further, the OCS is arranged at lateral sides of the plurality of battery modules.

The battery system of the present disclosure further comprises an optical communication system, OCS, which is configured to connect the BSM at least with the BMM of each battery module via optical signals. Therein, the OCS is configured such that the optical signals propagate inside at least one swelling compensation channel as described above. In other words, according to the present disclosure the OCS is integrated in the swelling compensation channels of a battery system, wherein such swelling compensation channels have to be commonly provided to housed battery systems anyway to account for swelling. Hence, the OCS advantageously has almost no additional construction space requirements.

Preferably, the OCS of the battery system is a free-space optical communication system, FSO. In other words, the OCS uses light propagating in free space of the swelling compensation channels in order to wirelessly transmit data between the BSM and BMMs. In the context of the present disclosure, the term "free space" refers to air or another a gas (mixture) inside the housing and does not refer to solids such as e.g., optical fiber cable.

In a preferred embodiment of the present disclosure, the battery modules are arranged in at least one row of battery modules. In other words, the battery modules are stacked in a linear manner in a rowing direction. According to this embodiment, at least one swelling compensation channel extends adjacent and along a row of battery modules. In other words, the swelling compensation channel may extend between two adjacent rows of battery modules or may extend between a row of battery modules and the housing. Usually, battery modules are arranged in the rows of battery modules such that the side walls of the rowed battery modules are aligned with each other. Hence, the swelling compensation channel can extend along the whole row of battery modules unobstructed, even through the whole system.

Further preferred, the swelling direction of the battery modules points to the at least one swelling compensation channel, particularly to a swelling compensation channel adjacent to the respective battery modules. Exemplarily, the swelling direction of the battery modules of a row of battery modules points to the at least one swelling compensation channel extending adjacent and along that row of battery modules. In other words, the relative positioning of the battery modules and the swelling compensation channels is done under consideration of the swelling direction, S, of the battery modules, so as to ensure reliable swelling compensation.

Particularly preferred, each battery cell of the battery system comprises a battery cell housing with a pair of wide side surfaces that are facing each other and a pair of narrow side surfaces that are facing each other, e.g., a prismatic battery cell housing. According to this embodiment, each battery module is formed by stacking the battery cells together with their wide side surfaces, such that the narrow side surfaces of all stacked battery cells form the side surface of the battery module. In this embodiment, the swelling direction, S, of each cell points in a normal direction of the wide side surfaces of that battery cell, as the wide side surfaces are usually those that are most prone to buckling when internal pressure increases. Thus, the swelling direction of a battery module is preferably parallel to its stacking direction.

The swelling compensation channels may further be configured to allow for compensation of tolerances, such as e.g., manufacturing tolerances or tolerances in thermal expansion or the like. The swelling compensation channels may further be configured to contribute to an electric and/or thermal insulation of the modules in a normal operation or in a thermal runaway operation. Also, the swelling compensation channels may allow for an unhindered vent gas flow between individual or compartmentalized battery modules in a thermal runaway situation, wherein such functions do not necessarily relate to a swelling direction of cells.

The OCS of the battery system preferably comprises a plurality of optical transmitters and a plurality of optical receivers which are configured to communicate with each other via the optical signals that are transmitted/received along the swelling compensation channel(s). Therein, the optical transmitters are configured to generate and output optical signals based on an analogue or digital input signal. The optical receivers are configured to receive the optical signals and to generate and output and output an analogue or digital output signal. Therein, the output signal resembles the input signal at least to a certain extend. The optical transmitters and receivers may be integral components of the battery system components, BSM, BMM (or BDU as described below) or may be separate components. If they are separate components, the connection to the battery system components may be via wires.

Particularly preferred, each BMM of the battery system comprises at least one optical transmitter configured for transmitting signals to the BSM and at least one optical receiver configured for receiving signals from the BSM. The optical transmitters and receivers may be connected to a transceiving control circuitry of the respective BMM configured for controlling the operation of the transmitter/receiver, i.e., for generating optical signals based on an internal input signal and to generate an output signal based on external optical signals.

The BSM comprises at least one optical transmitter and at least one optical receiver of the OCS. In other words, the BSM may comprise a single optical transmitter configured to transmit optical signals to the optical receivers of all BMMs and may comprise a single optical receiver configured to receive optical signals from the optical transmitters of all BMMs. However, the BSM may also comprise a plurality of optical transmitters, each optical transmitter being configured to transmit signals to an individual BMM or a group of BMMs. Likewise the BSM may comprise a plurality of optical receivers, each optical receiver being configured to receive signals from an individual BMM or from a group of BMMs. In other words, direct communication may be established between a BSM and each individual BMM. However, if the BSM comprises fewer optical transmitters/receivers than there are BMMs in the battery system, the communication between BSM and the BMMs is preferably sequential. However, the optical signals transmitted by the BSM may also be received by the optical receiver of each BMM and converted to an output signal, wherein an identifier of a BMM may be comprised in the output signal for identifying the actual recipient of the optical signal.

In a further preferred embodiment, the battery system further comprises a battery disconnect unit, BDU, which also comprises an optical transmitter and an optical receiver of the OCS. The BDU is configured to communicate with the BSM and to selectively connect or disconnect the plurality of battery modules from downstream loads under control of the BSM. Therefore, the BDU may comprise one or more relays or fuses interconnected between the plurality of battery modules and a system power terminal of the battery system. The relays of the BDU are preferably controlled by the BSM in response to a state of the battery system as detected by the BSM. Exemplarily, the BSM may control the relays to open, if a malfunction is detected in the battery system, e.g., based on the communication with the plurality of BMMs. The BSM communicates with and controls the BDU via optical signals that propagate to the optical transmitter and from the optical receiver of the BDU inside a swelling compensation channel, wherein this channel may be the same or different from those used for communication between the BSM and the BMMs. Due to high security requirements related to the operation of the BDU, preferably an individual channel is used for that communication.

In the battery system of the present disclosure, each swelling compensation channel is preferably configured to provide a direct line of sight between the at least one optical transmitter of the BSM and the optical receivers of the BMM and/or of the BDU. Likewise, each swelling compensation channel is preferably configured to provide a direct line of sight between the at least one optical receiver of the BSM and the optical transmitters of the BMM and/or of the BDU. Hence, the optical signals can advantageously propagate between the BSM and the BMMs/BDU without the use of any additional means such as glass fibres, mirrors, or the like. The swelling compensation channels usually extend in a linear manner along the rows of battery modules and through a whole battery system. Hence, optical communication can be carried out unobstructed via the swelling compensation channels.

In a particularly preferred embodiment, an optical transmitter of a first BMM comprises a spatial offset with respect to a direct line of sight between an optical transmitter of a second BMM (different from the first BMM) and an optical receiver of the BSM. In other words, the optical transmitter of the first BMM is not arranged in the direct line of sight between the optical transmitter of a second BMM and an optical receiver of the BSM. Further preferred, an optical receiver of a first BMM comprises a spatial offset with respect to a direct line of sight between an optical receiver of a second BMM (different from the first BMM) and an optical transmitter of the BSM. Hence, the communication between the first BMM and the BSM is not interfered by the communication between the second BMM and the BSM. In this embodiment, a first BMM is merely required to be different from a second BMM and a first BMM can be a second BMM with respect to another BMM. Particularly preferred, the optical transmitters and/or the optical receivers of all the BMMs are arranged with a spatial offset to each other. This embodiment advantageously avoids interference between the BMM communications.

Further preferred, the optical transmitters and the optical receivers are mounted via respective mounting structures to the BMMs, i.e., each optical transmitter and receiver is mounted to a BMM with a respective mounting structure. In such embodiment, the spatial offsets of a transmitter/receiver of a first BMM from the direct line of sight of the transmitter/receiver of a second BMM is preferably realized by using mounting structures of different sizes for the different BMMs, i.e., a first mounting structure for the first BMM and a second mounting structure for the second BMM. For an individual BMM, the optical transmitter and optical receiver may be mounted via a single mounting structure or separate mounting structures (e.g., also of different size) may be used for transmitter and receiver.

Alternatively or additionally, the spatial offsets between the optical transmitters and optical receivers of different BMMs are realized by spatial offsets of the battery modules with respect to the swelling compensation channel. In other words, instead of using different mounting structures for realizing a spatial offset, same mounting structures of identical size may be used, while the positioning of different battery modules to the swelling compensation channel differs. In this embodiment, the swelling compensation channel may have a stepped shape.

Also preferred, the different lines of sights between individual optical transmitters of BMMs and the BSM may be realized in that the optical transmitters of individual BMMs point toward the BSM under different angles. In such embodiment, the BSM may comprise a spatially extended optical receiver and a specific BMM may be identified based on a position of a detector area actually receiving the optical signal from that specific BMM. Further, different lines of sights between individual optical receivers of BMMs and the BSM may be realized in that the optical receivers of individual BMMs point toward the BSM under different angles. In such embodiment, the BSM may comprise multiple optical transmitters or an optical transmitter that is rotatable mounted to the BSM for emitting signals in different directions.

Preferably, the OCS of the battery system is configured to operate with infrared light, i.e., the optical transmitters are infrared transmitters and the optical receivers are infrared receivers. However, other optical communication system may also be employed such as e.g., laser-based communication system or visible light communication systems. The skilled person is aware of various optical communication systems and their respective advantages. Further preferred, the optical transmitters of the battery system comprise at least one LED and the optical receivers are one of a photodiode or phototransistors or the like.

Further preferred, at least one reflecting surface is disposed within the housing, e.g., as additional component, as part of the housing or as part of one or more battery modules. The at least one reflecting surface is configured to reflect light emitted from an optical transmitter as described above to a corresponding optical receiver as described above. In other words, the optical signals may also be deflected between the BSM and the BMMs/BDU. Exemplarily, the optical transmitters/receivers itself may not be disposed in the at least one swelling compensation channel but still the swelling compensation channel may be used as signal pathway by deflecting the optical signals in and out of the swelling compensation channel. Hence, the degrees of freedom in placing the transmitters/receivers can be further increased.

In a further preferred embodiment, the BSM does comprise a plurality of optical transmitter and, for each optical transmitter, a direct line of sight exists towards one optical receiver of a respective BMM. In other words, direct communication is realized between the BSM and the BMMs. Further preferred, a direct communication may be applied for a backward channel in that the BSM comprises a plurality of optical receivers and, for each optical receiver, a direct line of sight exists towards one optical transmitter of a respective BMM. However, also a mix of directed and non-directed communication for forward and backward channel may be used.

Another aspect of the present disclosure relates to an electric vehicle, comprising a battery system according to the present disclosure as described above. Further aspects of the present invention could be learned from the dependent claims or the following description.

### Brief Description of the Drawings

Features will become apparent to those of ordinary skill in the art by describing in detail exemplary embodiments with reference to the attached drawings in which:
- Fig. 1: illustrates a schematic top view of a battery system according to the prior art;
- Fig. 2: illustrates a perspective view of a battery cell according to an example;
- Fig. 3: illustrates a perspective view of a battery module according to an example;
- Fig. 4: illustrates a schematic top view of a battery system according to an embodiment;
- Fig. 5: illustrates a schematic perspective view of a section of the battery system according to Fig. 4; and
- Fig. 6: schematically illustrates the communication between a battery system monitor, BSM, and a plurality of battery module monitors, BMMs.

### Detailed Description of the Invention

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted. The present invention, however, may be embodied in various different forms, and should not be construed as being limited to only the illustrated embodiments herein. Rather, these embodiments are provided as examples so that this disclosure will be thorough and complete, and will fully convey the aspects and features of the present invention to those skilled in the art. Accordingly, processes, elements, and techniques that are not considered necessary to those having ordinary skill in the art for a complete understanding of the features of the present invention may not be described. In the drawings, the relative sizes of elements, layers, and regions may be exaggerated for clarity.

As used herein, the term "and/or" includes any and all combinations of one or more of the associated listed items. Further, the use of "may" when describing embodiments of the present invention refers to "one or more embodiments of the present invention." In the following description of embodiments of the present invention, the terms of a singular form may include plural forms unless the context clearly indicates otherwise. Expressions such as "at least one of," when preceding a list of elements, modify the entire list of elements and do not modify the individual elements of the list. It will be understood that although the terms "first" and "second" are used to describe various elements, these elements should not be limited by these terms. These terms are only used to distinguish one element from another element. For example, a first element may be named a second element and, similarly, a second element may be named a first element, without departing from the invention.

As used herein, the term "substantially," "about," and similar terms are used as terms of approximation and not as terms of degree, and are intended to account for the inherent deviations in measured or calculated values that would be recognized by those of ordinary skill in the art. Further, if the term "substantially" is used in combination with a feature that could be expressed numerically value, the term "substantially" denotes a range of +/- 5%.

Fig.1 shows a daisy chain setup according to the prior art and was already described above.

Fig. 2 is a perspective view illustrating a battery cell 10 according to an embodiment.

As shown in Fig. 2, the battery cell 10 according to an embodiment comprises a case 26 for accommodating an electrode assembly, the case 26 containing an electrolyte. The battery cell 10 further includes a cap assembly 14 for sealing an opening of the case 26. The case 26 is configured to have a substantially cuboidal shape, and an opening is formed at one side thereof. The case 26 is formed of a metal, such as aluminum, and includes a bottom surface having a substantially rectangular shape, a pair of first lateral walls, that are the wide side surfaces 19, and a pair of second lateral walls, that are narrow side surfaces 20. The first lateral walls 19 face each other, and the second lateral walls, 20 face each other and are connected to the first lateral walls 19. A length of an edge at which the cap assembly 14 and a first lateral wall 19 are connected to each other is longer than that of an edge at which the cap assembly 14 and the second lateral walls 20 are connected to each other.

The cap assembly 14 essentially is a cap plate 14 for covering the opening of the case 26 by being bonded to the case 26, and further include a positive terminal 11 (first terminal) and a negative terminal 12 (second terminal), which are externally protruded from the cap plate 14. The cap plate 14 includes a vent hole 13 that communicates with an interior of the cell 10. The vent hole 13 is configured to open due to a predetermined pressure. The positive terminal 11 and the negative terminal 12 protrude upward from the cap plate 14. A connecting plate 27 for electrically connecting the positive terminal 11 and the cap plate 14 is mounted between the positive terminal 11 and the cap plate 14 such that the cap plate 14 and the case 26 are electrified with same polarity. An upper insulating member 28 for electrically insulating the negative terminal 12 and the cap plate 14 is mounted between the negative terminal 12 and the cap plate 14 for insulation.

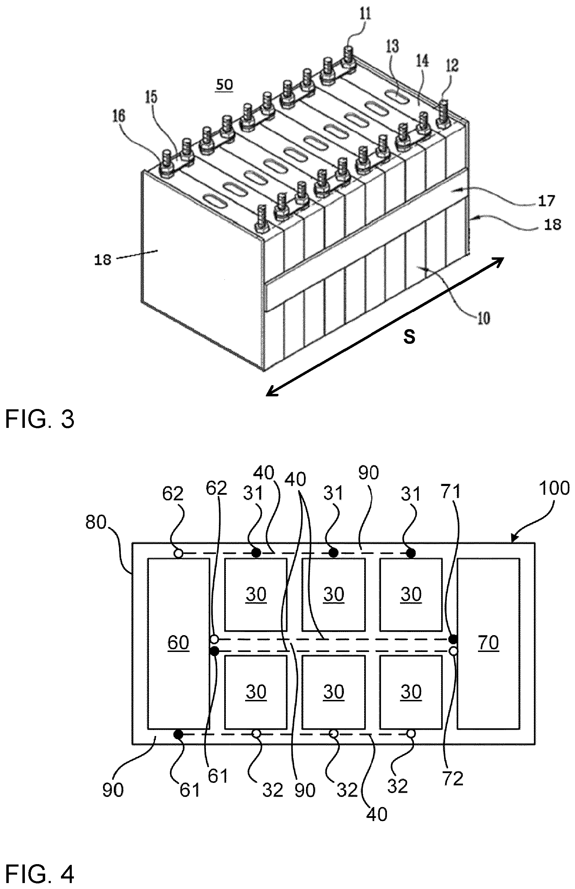

Referring to Fig. 3, an exemplary embodiment of a conventional battery module 50 includes a plurality of battery cells 10 aligned in one direction. A pair of end plates 18 are provided to face wide surfaces 19 of the battery cells 10 at the outside of the battery cells 10, and a connection plate 17 extends along the narrow side surfaces 20 and is configured to connect the pair of end plates 18 to each other thereby fixing the plurality of battery cells 10 together. Here, each battery cell 10 is a prismatic (or rectangular) cell and the wide side surfaces 19 of the cells 10 being stacked together to form the battery module 50. Further, the positive and negative electrode terminals 11 and 12 of neighboring cells 10 are electrically connected through a bus bar 15, and the bus bar 15 may be fixed by a nut 16, by welding, etc.

Referring to Fig. 4, a schematic top view of a battery system 100 according to an embodiment is shown. The battery system 100 comprises a plurality of six battery modules that are indicated by the battery module monitors, BMMs 30, which are disposed on top of each battery module. The battery system 100 further comprises a battery system monitor, BSM 60, and a battery disconnect unit, BDU 70. The battery modules, BMM 30, BSM 60 and BDU 70 are disposed in a housing 80 that is laterally enclosing all of these components.

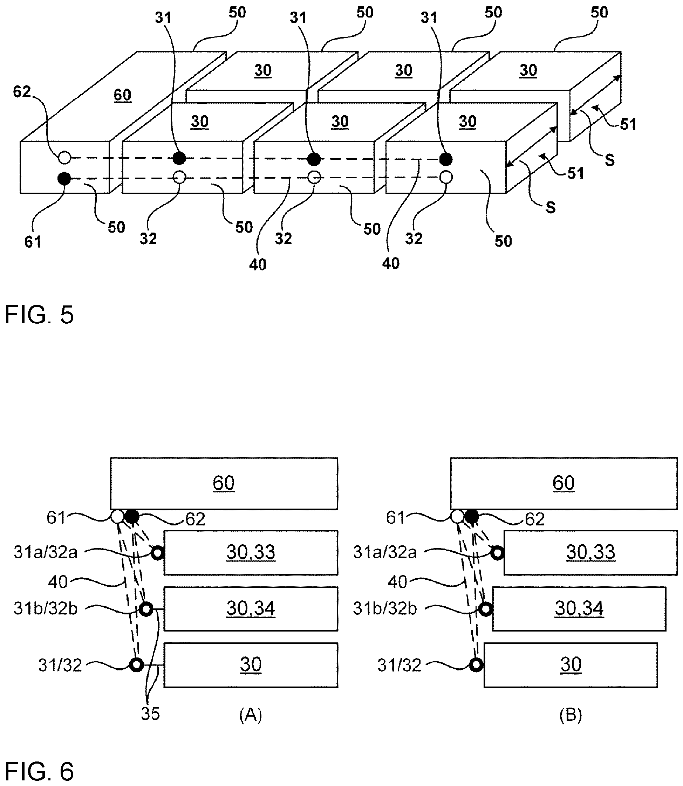

Fig. 5 illustrates a schematic perspective view of a section of the battery system 100 according to Fig. 4, particularly of the battery system 100 of Fig. 4 without the BDU 70. Referring to Figs. 4 and 5, the battery modules (and BMMs 30) of the battery system 100 are arranged in two rows 51, each row 51 comprising three battery modules (and BMMs 30). A swelling compensation channel 90 is formed between the two rows of battery modules (and BMMs 30) and further swelling compensation channels 90 are respectively formed between the rows of battery modules (and BMMs 30) and the housing 80. Therein, the battery modules are arranged such that a main swelling direction S as shown in Figure 3 is pointing into the swelling compensation channels 90, particularly that S is perpendicular to a longitudinal direction of the swelling compensation channels 90. As illustrated in Fig. 2, the main swelling direction of an individual battery cell 10 is normal to its wide side surfaces 19. Hence, if the cells 10 are stacked with their wide side surfaces 19 facing each other in the battery module 50 of Fig. 3, the main swelling direction of the module 50 is parallel to its stacking direction. Hence, in the battery system 100 of Figs. 4 and 5, the stacking direction of the battery modules 50 is also perpendicular to the longitudinal direction of the swelling compensation channels 90. Hence, the swelling of the battery cells 10 and modules 50 is compensated by the free space in the swelling compensation channels 90 to avoid damages.

As can be further seen in Figs. 4 and 5, the BSM 60 comprises three optical transmitters 61 and three optical receivers 62. Therein, as shown in Fig. 4 one optical transmitter 61 is arranged at a lower lateral side of the BSM 60 and is configured to perform a forward communication with the plurality of BMMs 30 at the lower row of battery modules. Therein, each BMM 30 comprises an optical receiver 32 that is in direct line of sight with said optical transmitter 61 of the BSM 60 within the lowermost swelling compensation channel 90. As further shown in Fig. 4, an optical receiver 62 is arranged at an upper lateral side of the BSM 60 and is configured to perform a backward communication with the plurality of BMMs 30 at the upper row of battery modules. Therein, each BMM 30 comprises an optical transmitter 31 that is in direct line of sight with said optical receiver 62 of the BSM 60 within the uppermost swelling compensation channel 90. As further shown in Fig. 4, the BSM comprises another optical transmitter 61 and another optical receiver 62 that are disposed at a right lateral side of the BSM 60 and that are in direct line of sight with respective optical receiver 72 and optical transmitter 71 of the BDU 70 within a middle swelling compensation channel 90. As shown in Fig. 5, another optical receiver 62 exists for backward communication with the lower row 51 of BMMs 30, each BMM 30 of which also comprises an optical transmitter 31, wherein the optical transmitters 31 and the another optical receiver 62 are not shown in Fig.4. The same holds true for the upper row 51 of BMMs 30, which are also set up for forward and for backward communication with the BSM 60.

Fig. 6 schematically illustrates the communication between a battery system monitor, BSM 60, and a plurality of battery module monitors, BMMs 30. Therein, Fig. 6 (A) and (B) illustrate that an optical transmitter 31a of a first BMM 33 comprises a spatial offset with respect to a direct line of sight between an optical transmitter 31b of a second BMM 34 and an optical receiver 62 of the BSM 60. Fig. 6 (A) and (B) further illustrate that an optical receiver 32a of the first BMM 33 comprises a spatial offset with respect to a direct line of sight between an optical receiver 32b of the second BMM 34 and an optical transmitter 61 of the BSM 60. Therein, the uppermost BMM 30 is the first BMM 33 and the middle BMM 30 is the second BMM 34, however this could also be reversed and also the middle BMM could be the first BMM 33 and the lowermost BMM 30 could be the second BMM 34. While in Fig. 6(A), the spatial offsets are realized by mounting structures 35 of different sizes that mount the optical transmitters 31 and optical receivers 32 (commonly illustrated as thick black circles) to the BMMs 30, in Fig. 6(B) the spatial offsets are realized by offsets of the BMMs 30 itself.

The electronic or electric devices and/or any other relevant devices or components according to embodiments of the present disclosure described herein may be implemented utilizing any suitable hardware, firmware (e.g. an application-specific integrated circuit), software, or a combination of software, firmware, and hardware. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate. The electrical connections or interconnections described herein may be realized by wires or conducting elements, e.g. on a PCB or another kind of circuit carrier. The conducting elements may comprise metallization, e.g. surface metallizations and/or pins, and/or may comprise conductive polymers or ceramics. Further electrical energy might be transmitted via wireless connections, e.g. using electromagnetic radiation and/or light.

Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like.

Also, a person of skill in the art should recognize that the functionality of various computing devices may be combined or integrated into a single computing device, or the functionality of a particular computing device may be distributed across one or more other computing devices without departing from the scope of the exemplary embodiments of the disclosure.

### Reference signs

- 10: battery cell
- 11: positive terminal
- 12: negative terminal
- 13: vent hole
- 14: cap plate
- 15: busbar
- 16: nut
- 17: connection plate
- 18: end plates
- 19: wide side surfaces
- 20: narrow side surfaces
- 26: battery cell housing
- 27: connecting plate
- 28: upper insulating member

- 30: battery module monitor, BMM
- 31a/b: first/second optical transmitter of BMM
- 32 a/b: first/second optical receiver of BMM
- 33: first BMM
- 34: second BMM
- 35: mounting structure

- 36: connector (prior art)
- 37: wiring harness (prior art)
- 38: busbar (prior art)

- 40: optical signal
- 50: battery module
- 51: row of battery modules

- 60: battery system monitor, BSM
- 61: optical transmitter of BSM
- 62: optical receiver of BSM

- 70: battery disconnect unit, BDU
- 71: optical transmitter of BDU
- 72: optical receiver of BDU

- 80: battery system housing

- 90: swelling compensation channel

- 100: battery system
- 101: positive battery system terminal (prior art)
- 102: negative battery system terminal (prior art)

- S: main swelling direction

## Claims

1. Battery system (100), comprising,
a plurality of battery modules (50), each comprising a plurality of stacked battery cells (10) and a battery module monitor, BMM (30), for monitoring the cells (10), wherein each BMM (30) is disposed on top of each battery module (50);
a battery system monitor, BSM (60), configured for communicating with and controlling the BMM (30) of each battery module (50);
a housing (80) enclosing the plurality of battery modules (50) and the BSM (60), wherein the battery modules (50) are arranged in the housing (80) such that at least one swelling compensation channel (90) is formed between the battery modules (50) and the housing (80);
an optical communication system, OCS (31, 32, 61, 62, 71, 72), configured to connect the BSM (60) with the BMM (30) of each battery module (50) via optical signals (40) propagating inside at least one swelling compensation channel (90);
**characterized in that**
the OCS (31, 32, 61, 62, 71, 72) is arranged at lateral sides of the plurality of battery modules (50).

2. Battery system (100) according to claim 1, wherein the battery modules (50) are arranged in at least one row of battery modules (51) and at least one swelling compensation channel (90) extends adjacent and along a row of battery modules (51).

3. Battery system (100) according to claim 1 or 2, wherein a swelling direction (S) of the battery modules (50) points to the at least one swelling compensation channel (90);
wherein each battery cell (10) comprises a battery cell housing (26) with a pair of wide side surfaces (19) facing each other and a pair of narrow side surfaces (20) facing each other, wherein each battery module (50) is formed by stacking the battery cells (10) together with their wide side surfaces (19), and wherein the swelling direction (S) of each cell is normal to the wide side surfaces (19).

4. Battery system (100) according to any preceding claim, wherein the OCS (31, 32, 61, 62, 71, 72) comprises a plurality of optical transmitters (31, 61, 71) and a plurality of optical receivers (32, 62, 72) configured to communicate with each other via the optical signals (40) transmitted/received along the swelling compensation channel (90).

5. Battery system (100) according to any preceding claim, wherein each BMM (30) comprises an optical transmitter (31) and an optical receiver (32) of the OCS.

6. Battery system (100) according to any preceding claim, wherein the BSM (60) comprises at least one optical transmitter (61) and at least one optical receiver (62) of the OCS.

7. Battery system (100) according to any preceding claim, further comprising a battery disconnect unit, BDU (70), with an optical transmitter (71) and an optical receiver (72) of the OCS, wherein the BSM (60) is configured for communicating with and controlling the BDU (70) via optical signals (40) that propagate to the optical transmitter (71) or from the optical receiver (72) of the BDU inside a swelling compensation channel (90).

8. Battery system (100) according to any preceding claim, wherein each swelling compensation channel (90) is configured to provide a direct line of sight between the optical transmitters (61) and receivers (62) of the BSM (60) and the optical transmitters (31, 71) and receivers (32, 72) of the BMM (30) and/or of the BDU (70).

9. Battery system (100) according to any preceding claim, wherein an optical transmitter (31a) of a first BMM (33) comprises a spatial offset with respect to a direct line of sight between an optical transmitter (31b) of a second BMM (34) and an optical receiver (62) of the BSM (60) and/or wherein an optical receiver (32a) of a first BMM (33) comprises a spatial offset with respect to a direct line of sight between an optical receiver (32b) of a second BMM (34) and an optical transmitter (61) of the BSM.

10. Battery system (100) according to claim 9, wherein the optical transmitters (31) and the optical receivers (32) are mounted via mounting structures (35) to the BMMs (30), respectively, and wherein the spatial offsets between optical transmitters (31) and optical receivers (32) of different BMMs (30) are realized by using mounting structures (35) of different sizes for the different BMMs (30).

11. Battery system (100) according to claim 9 or 10, wherein the spatial offsets between optical transmitters (31) and optical receivers (32) of different BMMs (30) are realized by spatial offsets of the battery modules (50) with respect to the swelling compensation channel (90).

12. Battery system (100) according to any preceding claim, wherein a direct line of sight between an optical transmitter (31a) of a first BMM (33) and an optical receiver (62) of the BSM (60) is angled to a direct line of sight between an optical transmitter (31b) of a second BMM (34) and the optical receiver (62) of the BSM (60) and/or wherein a direct line of sight between an optical receiver (32a) of a first BMM (33) and an optical transmitter (61) of the BSM (60) is angled to a direct line of sight between an optical receiver (32b) of a second BMM (34) and the optical transmitter (61) of the BSM (60).

13. Battery system (100) according to any preceding claim, wherein the OCS (31, 32, 61, 62, 71, 72) is configured to operate with infrared light and/or wherein at least one reflecting surface is disposed within the housing (80) and configured to reflect light emitted from an optical transmitter (31, 61, 71) to a corresponding optical receiver (32, 62, 72) of the OCS (31, 32, 61, 62, 71, 72).

14. Battery system (100) according to any preceding claim, wherein the BSM (60) comprises a plurality of optical transmitter (61) and, for each optical transmitter (61), a direct line of sight exists towards one optical receiver (32) of a respective BMM (30).

## Patentansprüche

1. Batteriesystem (100), umfassend
eine Vielzahl von Batteriemodulen (50), die jeweils eine Vielzahl von gestapelten Batteriezellen (10) und eine Batteriemodulüberwachungseinrichtung, BMM (30), zum Überwachen der Zellen (10) umfassen, wobei jede BMM (30) auf jedem Batteriemodul (50) angeordnet ist;
eine Batteriesystemüberwachungseinrichtung, BSM (60), die zum Kommunizieren mit und Steuern von der BMM (30) jedes Batteriemoduls (50) konfiguriert ist;
ein Gehäuse (80), das die Vielzahl von Batteriemodulen (50) und die BSM (60) umschließt, wobei die Batteriemodule (50) derart in dem Gehäuse (80) angeordnet sind, dass mindestens ein Schwellungskompensationskanal (90) zwischen den Batteriemodulen (50) und dem Gehäuse (80) ausgebildet ist;
ein optisches Kommunikationssystem, OCS (31, 32, 61, 62, 71, 72), das konfiguriert ist, um die BSM (60) über optische Signale (40), die sich innerhalb mindestens eines Schwellungskompensationskanals (90) ausbreiten, mit der BMM (30) jedes Batteriemoduls (50) zu verbinden;
**dadurch gekennzeichnet, dass**
das OCS (31, 32, 61, 62, 71, 72) an lateralen Seiten der Vielzahl von Batteriemodulen (50) angeordnet ist.

2. Batteriesystem (100) nach Anspruch 1, wobei die Batteriemodule (50) in mindestens einer Reihe von Batteriemodulen (51) angeordnet sind und sich mindestens ein Schwellungskompensationskanal (90) benachbart zu und entlang einer Reihe von Batteriemodulen (51) erstreckt.

3. Batteriesystem (100) nach Anspruch 1 oder 2, wobei eine Schwellungsrichtung (S) der Batteriemodule (50) zu dem mindestens einen Schwellungskompensationskanal (90) zeigt;
wobei jede Batteriezelle (10) ein Batteriezellengehäuse (26) mit einem Paar einander zugewandter breiter Seitenflächen (19) und einem Paar einander zugewandter schmaler Seitenflächen (20) umfasst, wobei jedes Batteriemodul (50) durch Aneinanderstapeln der Batteriezellen (10) mit ihren breiten Seitenflächen (19) ausgebildet ist und wobei die Schwellungsrichtung (S) jeder Zelle senkrecht zu den breiten Seitenflächen (19) verläuft.

4. Batteriesystem (100) nach einem der vorhergehenden Ansprüche, wobei das OCS (31, 32, 61, 62, 71, 72) eine Vielzahl von optischen Sendern (31, 61, 71) und eine Vielzahl von optischen Empfängern (32, 62, 72) umfasst, die konfiguriert sind, um über die entlang des Schwellungskompensationskanals (90) gesendeten/empfangenen optischen Signale (40) miteinander zu kommunizieren.

5. Batteriesystem (100) nach einem der vorhergehenden Ansprüche, wobei jede BMM (30) einen optischen Sender (31) und einen optischen Empfänger (32) des OCS umfasst.

6. Batteriesystem (100) nach einem der vorhergehenden Ansprüche, wobei die BSM (60) mindestens einen optischen Sender (61) und mindestens einen optischen Empfänger (62) des OCS umfasst.

7. Batteriesystem (100) nach einem der vorhergehenden Ansprüche, ferner umfassend eine Batterietrenneinheit, BDU (70), mit einem optischen Sender (71) und einem optischen Empfänger (72) des OCS, wobei die BSM (60) zum Kommunizieren mit und Steuern von der BDU (70) über optische Signale (40), die sich innerhalb eines Schwellungskompensationskanals (90) zu dem optischen Sender (71) oder von dem optischen Empfänger (72) der BDU ausbreiten, konfiguriert ist.

8. Batteriesystem (100) nach einem der vorhergehenden Ansprüche, wobei jeder Schwellungskompensationskanal (90) konfiguriert ist, um eine direkte Sichtlinie zwischen den optischen Sendern (61) und Empfängern (62) der BSM (60) und den optischen Sendern (31, 71) und Empfängern (32, 72) der BMM (30) und/oder der BDU (70) bereitzustellen.

9. Batteriesystem (100) nach einem der vorhergehenden Ansprüche, wobei ein optischer Sender (31a) einer ersten BMM (33) einen räumlichen Versatz in Bezug auf eine direkte Sichtlinie zwischen einem optischen Sender (31b) einer zweiten BMM (34) und einem optischen Empfänger (62) der BSM (60) umfasst und/oder wobei ein optischer Empfänger (32a) einer ersten BMM (33) einen räumlichen Versatz in Bezug auf eine direkte Sichtlinie zwischen einem optischen Empfänger (32b) einer zweiten BMM (34) und einem optischen Sender (61) der BSM umfasst.

10. Batteriesystem (100) nach Anspruch 9, wobei die optischen Sender (31) und die optischen Empfänger (32) jeweils über Montagestrukturen (35) an den BMMs (30) montiert sind und wobei die räumlichen Versätze zwischen optischen Sendern (31) und optischen Empfängern (32) verschiedener BMMs (30) durch Verwenden von Montagestrukturen (35) unterschiedlicher Größen für die verschiedenen BMMs (30) realisiert sind.

11. Batteriesystem (100) nach Anspruch 9 oder 10, wobei die räumlichen Versätze zwischen optischen Sendern (31) und optischen Empfängern (32) verschiedener BMMs (30) durch räumliche Versätze der Batteriemodule (50) in Bezug auf den Schwellungskompensationskanal (90) realisiert sind.

12. Batteriesystem (100) nach einem der vorhergehenden Ansprüche, wobei eine direkte Sichtlinie zwischen einem optischen Sender (31a) einer ersten BMM (33) und einem optischen Empfänger (62) der BSM (60) zu einer direkten Sichtlinie zwischen einem optischen Sender (31b) einer zweiten BMM (34) und dem optischen Empfänger (62) der BSM (60) abgewinkelt ist und/oder wobei eine direkte Sichtlinie zwischen einem optischen Empfänger (32a) einer ersten BMM (33) und einem optischen Sender (61) der BSM (60) zu einer direkten Sichtlinie zwischen einem optischen Empfänger (32b) einer zweiten BMM (34) und dem optischen Sender (61) der BSM (60) abgewinkelt ist.

13. Batteriesystem (100) nach einem der vorhergehenden Ansprüche, wobei das OCS (31, 32, 61, 62, 71, 72) konfiguriert ist, um mit Infrarotlicht betrieben zu werden, und/oder wobei mindestens eine reflektierende Fläche innerhalb des Gehäuses (80) angeordnet und konfiguriert ist, um von einem optischen Sender (31, 61, 71) emittiertes Licht zu einem entsprechenden optischen Empfänger (32, 62, 72) des OCS (31, 32, 61, 62, 71, 72) zu reflektieren.

14. Batteriesystem (100) nach einem der vorhergehenden Ansprüche, wobei die BSM (60) eine Vielzahl von optischen Sendern (61) umfasst und für jeden optischen Sender (61) eine direkte Sichtlinie zu einem optischen Empfänger (32) einer jeweiligen BMM (30) vorhanden ist.

## Revendications

1. Système de batterie (100), comportant :
une pluralité de modules de batterie (50), comportant chacun une pluralité d'éléments de batterie (10) empilés et un dispositif de surveillance de module de batterie, BMM (30), pour surveiller les éléments (10), dans lequel chaque BMM (30) est disposé au-dessus de chaque module de batterie (50) ;
un dispositif de surveillance de système de batterie, BSM (60), configuré pour communiquer avec le BMM (30) de chaque module de batterie (50) et le commander ;
un boîtier (80) renfermant la pluralité de modules de batterie (50) et le BSM (60), dans lequel les modules de batterie (50) sont agencés dans le boîtier (80) de sorte qu'au moins un canal de compensation de gonflement (90) soit formé entre les modules de batterie (50) et le boîtier (80) ;
un système de communication optique, OCS (31, 32, 61, 62, 71, 72), configuré pour connecter le BSM (60) au BMM (30) de chaque module de batterie (50) via des signaux optiques (40) se propageant à l'intérieur d'au moins un canal de compensation de gonflement (90) ;
**caractérisé en ce que**
l'OCS (31, 32, 61, 62, 71, 72) est agencé sur des côtés latéraux de la pluralité de modules de batterie (50).

2. Système de batterie (100) selon la revendication 1, dans lequel les modules de batterie (50) sont agencés dans au moins une rangée de modules de batterie (51) et au moins un canal de compensation de gonflement (90) s'étend de manière adjacente à une rangée de modules de batterie (51) et le long de celle-ci.

3. Système de batterie (100) selon la revendication 1 ou 2, dans lequel une direction de gonflement (S) des modules de batterie (50) pointe vers l'au moins un canal de compensation de gonflement (90) ;
dans lequel chaque élément de batterie (10) comporte un boîtier d'élément de batterie (26) avec une paire de surfaces latérales larges (19) orientées l'une vers l'autre et une paire de surfaces latérales étroites (20) orientées l'une vers l'autre, dans lequel chaque module de batterie (50) est formé par empilement des éléments de batterie (10) avec leurs surfaces latérales larges (19), et dans lequel la direction de gonflement (S) de chaque élément est normale aux surfaces latérales larges (19).

4. Système de batterie (100) selon une quelconque revendication précédente, dans lequel l'OCS (31, 32, 61, 62, 71, 72) comporte une pluralité d'émetteurs optiques (31, 61, 71) et une pluralité de récepteurs optiques (32, 62, 72) configurés pour communiquer entre eux via les signaux optiques (40) émis/reçus le long du canal de compensation de gonflement (90).

5. Système de batterie (100) selon une quelconque revendication précédente, dans lequel chaque BMM (30) comporte un émetteur optique (31) et un récepteur optique (32) de l'OCS.

6. Système de batterie (100) selon une quelconque revendication précédente, dans lequel le BSM (60) comporte au moins un émetteur optique (61) et au moins un récepteur optique (62) de l'OCS.

7. Système de batterie (100) selon une quelconque revendication précédente, comportant en outre une unité de déconnexion de batterie, BDU (70), avec un émetteur optique (71) et un récepteur optique (72) de l'OCS, dans lequel le BSM (60) est configuré pour communiquer avec la BDU (70) et la commander via des signaux optiques (40) qui se propagent vers l'émetteur optique (71) ou à partir du récepteur optique (72) de la BDU à l'intérieur d'un canal de compensation de gonflement (90).

8. Système de batterie (100) selon une quelconque revendication précédente, dans lequel chaque canal de compensation de gonflement (90) est configuré pour fournir une ligne de visée directe entre les émetteurs (61) et récepteurs optiques (62) du BSM (60) et les émetteurs (31, 71) et récepteurs optiques (32, 72) du BMM (30) et/ou de la BDU (70).

9. Système de batterie (100) selon une quelconque revendication précédente, dans lequel un émetteur optique (31a) d'un premier BMM (33) comporte un décalage spatial par rapport à une ligne de visée directe entre un émetteur optique (31b) d'un deuxième BMM (34) et un récepteur optique (62) du BSM (60) et/ou dans lequel un récepteur optique (32a) d'un premier BMM (33) comporte un décalage spatial par rapport à une ligne de visée directe entre un récepteur optique (32b) d'un deuxième BMM (34) et un émetteur optique (61) du BSM.

10. Système de batterie (100) selon la revendication 9, dans lequel les émetteurs optiques (31) et les récepteurs optiques (32) sont montés via des structures de montage (35) sur les BMM (30), respectivement, et dans lequel les décalages spatiaux entre les émetteurs optiques (31) et les récepteurs optiques (32) de différents BMM (30) sont réalisés en utilisant des structures de montage (35) de tailles différentes pour les différents BMM (30).

11. Système de batterie (100) selon la revendication 9 ou 10, dans lequel les décalages spatiaux entre les émetteurs optiques (31) et les récepteurs optiques (32) de différents BMM (30) sont réalisés par des décalages spatiaux des modules de batterie (50) par rapport au canal de compensation de gonflement (90).

12. Système de batterie (100) selon une quelconque revendication précédente, dans lequel une ligne de visée directe entre un émetteur optique (31a) d'un premier BMM (33) et un récepteur optique (62) du BSM (60) est inclinée vers une ligne de visée directe entre un émetteur optique (31b) d'un deuxième BMM (34) et le récepteur optique (62) du BSM (60) et/ou dans lequel une ligne de visée directe entre un récepteur optique (32a) d'un premier BMM (33) et un émetteur optique (61) du BSM (60) est inclinée vers une ligne de visée directe entre un récepteur optique (32b) d'un deuxième BMM (34) et l'émetteur optique (61) du BSM (60).

13. Système de batterie (100) selon une quelconque revendication précédente, dans lequel l'OCS (31, 32, 61, 62, 71, 72) est configuré pour fonctionner avec une lumière infrarouge et/ou dans lequel au moins une surface réfléchissante est disposée à l'intérieur du boîtier (80) et configurée pour réfléchir une lumière émise par un émetteur optique (31, 61, 71) vers un récepteur optique (32, 62, 72) correspondant de l'OCS (31, 32, 61, 62, 71, 72).

14. Système de batterie (100) selon une quelconque revendication précédente, dans lequel le BSM (60) comporte une pluralité d'émetteurs optiques (61) et, pour chaque émetteur optique (61), il existe une ligne de visée directe vers un récepteur optique (32) d'un BMM (30) respectif.
